# EUROPEAN PATENT SPECIFICATION

(11) **EP 3 789 775 B1**
(45) Date of publication and mention of the grant of the patent: **18.10.2023**
(21) Application number: 19195445.2
(22) Date of filing: 04.09.2019
(51) Int. Cl.: G01R 15/14, G01R 15/20

(54) **A HIGH-POWER ELECTRONICS ASSEMBLY**
HOCHLEISTUNGSELEKTRONIKBAUGRUPPE
ENSEMBLE ÉLECTRONIQUE DE HAUTE PUISSANCE

(43) Date of publication of application: 10.03.2021
(73) Proprietor: BRUSA Elektronik AG, 9466 Sennwald (CH)
(72) Inventor: Krause, Axel, 9650 Nesslau (CH)
(74) Representative: Rösler Rasch van der Heide & Partner

(56) References cited:
- EP-A1- 0 578 948
- EP-A1- 1 015 896
- US-A1- 2005 030 004
- US-A1- 2007 164 727
- US-A1- 2018 275 172

## Description

The present invention relates to current sensor assemblies for measuring high power electric current, wherein high power electric currents may have more than 10 amperes and preferably are in the range of one to several hundred amperes. Current sensor assemblies with a conductor and a magnetic field sensor are determining an electric current in the conductor by measuring the magnetic field generated by the electric current. The accuracy of the determined value for the electric current can be improved by a magnetic component bundling magnetic field lines.

DE 40 28 614 A1 is disclosing a current sensor assembly for measuring high power electric currents with a Hall sensor arranged in the slot of a ferrite ring. The conductor is extending through the ferrite ring. An electric current in the conductor is generating a magnetic field around the conductor, wherein the ferrite ring is bundling magnetic field lines and guiding them through the Hall sensor arranged in the slot of a ferrite ring. The accuracy of current measurements made with this current sensor is not sufficient. Measurements can be disturbed by external magnetic fields which exist in specific measurement settings. Other examples of similar current sensing devices can be seen in US 2005/030004 A1 and EP 1 015 896 A1.

It is therefore an object of the present invention to improve the accuracy of high power electric current measurements in all possible measurement settings, preferably for all different electric current values and/or for settings with external magnetic fields.

At least parts of these objects are achieved by realizing the features of the independent claim. Features which further develop the invention in an alternative or advantageous manner are described in the dependent patent claims.

The invention is defined by the high-power electronics assembly for measuring high power electric current according to claim 1.

Arranging the magnetic field sensor between the first and the second conductor section and arranging the magnetic component in a closed ring shape around the magnetic field sensor and the first and the second conductor section improves the accuracy of high power electric current measurements in all possible measurement settings. At the magnetic field sensor, the magnetic field generated by the electric current in the conductor is concentrated and has an improved homogeneity.

The magnetic component is a component that allows guiding of magnetic field lines and consists of a ferromagnetic or a ferrimagnetic material, e.g. of a ferrite or an iron- or nickel-based magnetic alloy material. For example, a ferrite is a ceramic material made by mixing and firing large proportions of iron(III) oxide (Fe2O3, rust) blended with small proportions of one or more additional metallic elements, such as barium, manganese, nickel, and zinc. Magnetic materials can be divided into two families, i.e. hard magnetic and soft magnetic materials, based on their resistance to being demagnetized (magnetic coercivity). Magnetic hard materials have high coercivity, so are difficult to demagnetize, whereas magnetic soft materials have low coercivity, so they easily change their magnetization. In other words: magnetic materials act as conductors of magnetic fields, which is the actual measurement parameter in a current measuring principle in the sense of the invention. By way of example, the magnetic component comprises a magnetically soft material which can easily change its magnetization, which, for example, is beneficial to provide an arrangement wherein the strength of the magnetic field corresponds to the excitation current in the best possible way regarding linearity and low hysteresis. However, the use of a magnetic component based on a magnetically hard material is not excluded.

Electric current in the conductor is flowing through the first and the second conductor section. The arrangement of the first, the connecting and the second conductor section in series and the arrangement of the first conductor section and the second conductor section along an assembly axis from a first axial end to a second axial end of a central sensor area ensure that in respect of a fixed direction along the assembly axis the electric current in the first and in the second conductor section is anytime directed in opposite directions. For this reason, the magnetic field strength at the assembly axis is twice as strong as the field strength of the field emanating just from the first or just from the second conductor section. The field lines in a range of the assembly axis between the first and the second conductor section are perpendicular to a plane including the first and the second conductor section wherein for the localization of this plane the conductors are imagined as infinite thin wires.

In a preferred embodiment, the first section, the connecting section and the second section of the conductor form a U-shaped conductor loop. The magnetic field sensor can be placed with its centerline at the assembly axis and with an orientation to generate maximum measurements. The measurements are further improved if the magnetic field sensor is arranged in a central position also in-between the first and the second end of the central sensor area.

The magnetic field at a centrally positioned magnetic field sensor is rather homogeneous and optimally strong. The homogeneity can be further improved by forming the first, the connecting and the second conductor sections as sections of a conductor rail, preferably of a ribbon-shaped conductor rail, wherein the width of the ribbon-shaped conductor rail is extending parallel to the magnetic field lines at the assembly axis.

Effects of external magnetic fields are minimized by the magnetic component arranged in a closed ring shape around the assembly axis and around the magnetic field sensor and the first and the second section of the conductor. This allows bundling magnetic field lines and thereby guiding external magnetic fields around the central sensor area with the first conductor section, the second conductor section and the magnetic field sensor. The improved quality of measurements of the magnetic field sensor is due to reduced external effects and to improved homogeneity and intensity of the magnetic field generated by the electric current in the first and second conductor section. The improved quality allows precise measurements of the electric current for all different electric current values and/or for settings with external magnetic fields.

The accuracy of measurements made by the magnetic field sensor can be improved by efficiently produced magnetic components. In a preferred embodiment the magnetic component has a shape of a hollow cylinder with a defined wall thickness, wherein the hollow cylinder extends along the assembly axis, particularly wherein the ends of the first and second section of the conductor connecting to the ends of the connecting section are arranged at the same axial position along the assembly axis.

By way of example, the outline of the hollow cylinder is a cylinder having one of a circular cylinder base, an elliptical cylinder base, and a polygonal cylinder base with sharp or rounded corners, particularly the base being a regular polygon, more particularly a rectangle.

For example, the magnetic component has a shape of a round tube, a hollow rectangular prism, or a hexagonal prism.

The production of a closed ferrite ring element is simpler than the production of a ferrite ring with a slot for a magnetic field sensor.

In a further preferred embodiment the magnetic component has a three-dimensional concave or pot-like shape, wherein the magnetic field sensor, the first conductor section, the connecting conductor section and the second conductor section are enclosed by the three-dimensional concave or pot-like outline of the magnetic component, e.g. wherein connections to the enclosed elements protrude through the pot opening into the magnetic component.

The magnetic field sensor is a sensor for detecting magnetic fields. A preferred group of magnetic field sensors are galvanomagnetic field sensors, which are detecting the magnetic field generated by the electric current by detecting electric or thermic effects occurring at a sensor conductor with an electric sensor current in the magnetic field. In a preferred embodiment the magnetic field sensor is a Hall sensor.

In another preferred embodiment the magnetic field sensor comprises a magneto-electric composite, which can directly generate an electric signal in response to a magnetic field, leading to a sensor with a passive nature without the need of an external power source.

In a preferred embodiment the magnetic field sensor, the first conductor section, the second conductor section and the magnetic component are part of a potted unit of the high-power electronics (i.e. current sensor assembly). Thereby, the effect of vibrations on the accuracy of the measurement values is reduced.

In settings where several currents have to be measured it is advantageous to arrange at least two conductors each including in series a first conductor section, a connecting conductor section and a second conductor section as well as corresponding magnetic field sensors along a multi sensor axis wherein the magnetic field sensors are arranged on a common circuit board and magnetic components are surrounding each magnetic field sensor and the corresponding first and second conductor sections.

A further preferred embodiment allows to measure several currents with a compact electronics assembly including arrangements of conductors and magnetic field sensors arranged along at least two parallel multi sensor axes, wherein magnetic field sensors of adjacent multi sensor axes are arranged adjacent to each other.

The current sensor assembly according to the invention is described or explained in more detail below, purely by way of example, with reference to working examples shown schematically in the drawing. Identical elements are labelled with the same reference numerals in the figures. The described embodiments are generally not shown true to scale and they are also not to be interpreted as limiting the invention. Specifically,
- Fig. 1:: a perspective presentation of a current sensor assembly with a cylindrical magnetic component, wherein a front part of the magnetic component is cut away to show the central sensor area;
- Fig. 2:: a sectional view of the current sensor assembly of Fig. 1, wherein the assembly is cut at a plane perpendicular to the assembly axis;
- Fig. 3:: a perspective presentation of a current sensor assembly with a magnetic component enclosing the central sensor area from five sides, wherein a front part of the magnetic component is cut away to show the central sensor area.

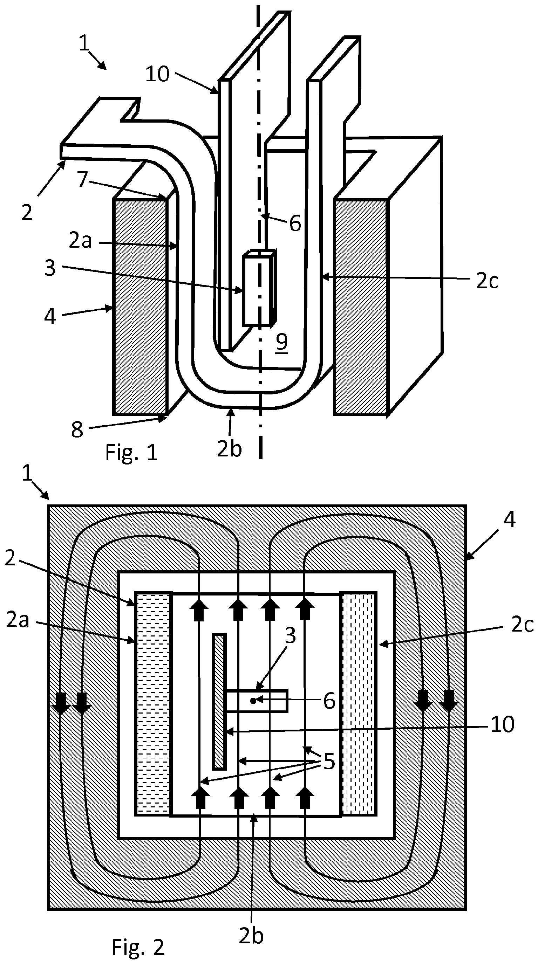

Figure 1 and 2 show an embodiment of the current sensor assembly 1 for measuring high power electric current in a conductor 2 with a magnetic field sensor 3, e.g. a Hall effect sensor. The magnetic component 4 is guiding or bundling, respectively, the magnetic field lines 5 generated by the electric current flowing in the conductor 2.

The conductor 2 includes in series a first conductor section 2a, a connecting conductor section 2b and a second conductor section 2c, wherein the first conductor section 2a and the second conductor section 2c are extending along an assembly axis 6 from a first axial end 7 to a second axial end 8 of a central sensor area 9 and the connecting conductor section 2b is connecting the first conductor section 2a to the second conductor section 2b at the second axial end 8 of the central sensor area 9.

The conductor 2 forms with the first conductor section 2a, the connecting conductor section 2b and the second conductor section 2c a U-shaped conductor rail in the form of a ribbon, wherein the width of the ribbon-shaped conductor rail is extending parallel to the magnetic field lines 5 at the assembly axis 6. In Fig. 2 the cut first conductor section 2a and the cut second conductor section 2c are displayed with different patterns, indicating the opposite directions of a current in the two sections, in one up and in the other down.

The magnetic field sensor 3 is arranged between the first conductor section 2a and the second conductor section 2c, wherein the magnetic field sensor 3 is mounted on a holding and connecting element 10. Electrical connecting lines are arranged at the holding and connecting element 10 and are connecting the magnetic field sensor 3 to a sensor control system.

The magnetic component 4 is arranged in a closed rectangular ring shape around the assembly axis 6 and it is surrounding the magnetic field sensor 3 and the first and the second section of the conductor 2a, 2c. The magnetic component is a magnetisable component 4 that allows guiding of the magnetic field lines 5. The magnetic component 4 acts as conductor of magnetic fields. A preferred magnetic component comprises soft magnetic material, e.g. a soft ferrite.

In a preferred embodiment the central sensor area 9 with the magnetic field sensor, the first conductor section, the second conductor section and the magnetic component are part of a potted unit of the current sensor assembly, wherein the originally void region of the central sensor area 9 is filled with a solid or gelatinous compound for resistance to shock and vibration, and for exclusion of moisture and corrosive agents. Thereby, the effect of vibrations on the accuracy of the measurement values is reduced.

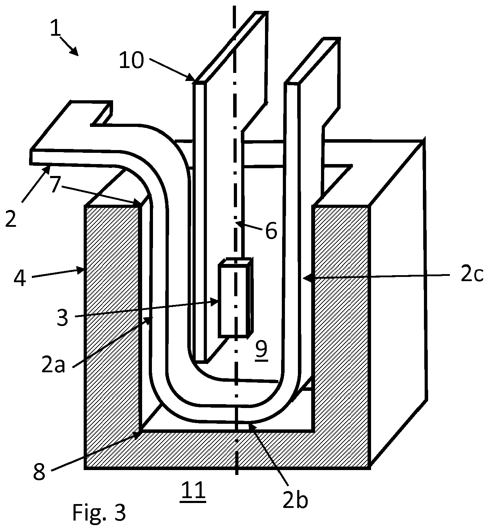

Figure 3 shows an embodiment where the magnetic component is embodied as a ferrite, wherein the ferrite core has a concave or pot-like shape, i.e. one side of the rectangular tube is closed. The field lines are guided also in the bottom area 11 to prevent the influence of magnetic fields existing at the bottom.

The invention is defined by the appended claims.

## Claims

1. A high-power electronics assembly (1) for measuring high power electric current, comprising
• a conductor (2),
• a magnetic component (4) for bundling magnetic field lines generated by the electric current flowing in the conductor (2), and
• a magnetic field sensor (3) for determining the electric current flowing in the conductor (2) based on a measured magnetic field,
wherein
• the conductor (2) includes in series a first conductor section (2a), a connecting conductor section (2b) and a second conductor section (2c), wherein the first conductor section (2a) and the second conductor section (2c) are extending along an assembly axis (6) from a first axial end (7) to a second axial end (8) of a central sensor area (9) and the connecting conductor section (2b) is connecting the first conductor section (2a) to the second conductor section (2c),
• the magnetic field sensor (3) is arranged between the first conductor section (2a) and the second conductor section (2c), and
• the magnetic component (4) is arranged in a ring shape, in particular closed ring shape, around the assembly axis (6) and it is surrounding the magnetic field sensor (3), the first conductor section (2a) and the second conductor section (2c),
**characterized in that**
the first conductor section (2a), the connecting conductor section (2b) and the second conductor section (2c) are formed as sections of a ribbon-shaped conductor rail, wherein the width of the ribbon-shaped conductor rail is extending parallel to the magnetic field lines (5) at the assembly axis (6).

2. A high-power electronics assembly (1) according to claim 1,
**characterized in that**
the first conductor section (2a), the connecting conductor section (2b) and the second conductor section (2c) form a U-shaped conductor loop.

3. A high-power electronics assembly (1) according to one of claims 1 to 2,
**characterized in that**
the magnetic field sensor (3), the first conductor section (2a), the second conductor section (2c) and the magnetic component (4) are part of a potted unit of the high-power electronics assembly (1).

4. A high-power electronics assembly (1) according to one of claims 1 to 3, **characterized in that** the magnetic component (4) has a shape of a hollow cylinder extending along the assembly axis (6), particularly wherein the ends of the first conductor section (2a) and of the second conductor section (2c) connecting to the ends of the connecting section (2b) are arranged at the same axial position along the assembly axis (6).

5. A high-power electronics assembly (1) according to claim 4, **characterized in that** the outline of the hollow cylinder is a cylinder having one of
• a circular cylinder base,
• an elliptical cylinder base, and
• a polygonal cylinder base with sharp or rounded corners, particularly the base being a regular polygon, more particularly a rectangle.

6. A high-power electronics assembly (1) according to claim 4 or 5,
**characterized in that**
the magnetic component (4) has a three-dimensional concave or pot-like shape, wherein the magnetic field sensor (3), the first conductor section (2a), the connecting conductor section (2b) and the second conductor section (2c) are enclosed by the three-dimensional outline of the magnetic component (4).

7. A high-power electronics assembly (1) according to one of claims 1 to 6,
**characterized in that**
the magnetic field sensor (3) is a Hall sensor.

8. A high-power electronics assembly (1) according to one of claims 1 to 7,
**characterized in that**
the magnetic field sensor (3) is an integrated circuit comprising a sensor element.

9. A high-power electronics assembly (1) according to one of claims 1 to 8,
**characterized in that**
at least two conductors (2) each including in series a first conductor section (2a), a connecting conductor section (2b) and a second conductor section (2c) as well as corresponding magnetic field sensors (3) are arranged along a multi sensor axis wherein magnetic field sensors (3) are arranged on a common circuit board and magnetic components (4) are surrounding each magnetic field sensor (3) and the corresponding first and second conductor sections (2a, 2c).

10. A high-power electronics assembly (1) according to claim 9,
**characterized in that**
at least two arrangements of conductors (2) and magnetic field sensors (3) are arranged along at least two parallel multi sensor axis wherein magnetic field sensors (3) of adjacent multi sensor axis are arranged adjacent to each other.

## Patentansprüche

1. Hochleistungselektronikbaugruppe (1) zum Messen von Hochleistungsstrom, welche umfasst:
• einen Leiter (2),
• eine magnetische Komponente (4) zum Bündeln von Magnetfeldlinien, die durch den im Leiter (2) fließenden elektrischen Strom erzeugt werden, und
• einen Magnetfeldsensor (3) zum Bestimmen des im Leiter (2) fließenden elektrischen Stroms basierend auf einem gemessenen Magnetfeld,
wobei
• der Leiter (2) einen ersten Leiterabschnitt (2a), einen verbindenden Leiterabschnitt (2b) und einen zweiten Leiterabschnitt (2c), die in Reihe geschaltet sind, aufweist, wobei sich der erste Leiterabschnitt (2a) und der zweite Leiterabschnitt (2c) entlang einer Baugruppenachse (6) von einem ersten axialen Ende (7) bis zu einem zweiten axialen Ende (8) eines zentralen Sensorbereichs (9) erstrecken und der verbindende Leiterabschnitt (2b) den ersten Leiterabschnitt (2a) mit dem zweiten Leiterabschnitt (2c) verbindet,
• der Magnetfeldsensor (3) zwischen dem ersten Leiterabschnitt (2a) und dem zweiten Leiterabschnitt (2c) angeordnet ist, und
• die magnetische Komponente (4) in einer Ringform, insbesondere einer geschlossenen Ringform, um die Baugruppenachse (6) herum angeordnet ist und den Magnetfeldsensor (3), den ersten Leiterabschnitt (2a) und den zweiten Leiterabschnitt (2c) umgibt,
**dadurch gekennzeichnet, dass**
der erste Leiterabschnitt (2a), der verbindende Leiterabschnitt (2b) und der zweite Leiterabschnitt (2c) als Abschnitte einer bandförmigen Leiterschiene ausgebildet sind, wobei sich die Breite der bandförmigen Leiterschiene parallel zu den Magnetfeldlinien (5) an der Baugruppenachse (6) erstreckt.

2. Hochleistungselektronikbaugruppe (1) nach Anspruch 1,
**dadurch gekennzeichnet, dass**
der erste Leiterabschnitt (2a), der verbindende Leiterabschnitt (2b) und der zweite Leiterabschnitt (2c) eine U-förmige Leiterschleife bilden.

3. Hochleistungselektronikbaugruppe (1) nach einem der Ansprüche 1 bis 2,
**dadurch gekennzeichnet, dass**
der Magnetfeldsensor (3), der erste Leiterabschnitt (2a), der zweite Leiterabschnitt (2c) und die magnetische Komponente (4) Teil einer vergossenen Einheit der Hochleistungselektronikbaugruppe (1) sind.

4. Hochleistungselektronikbaugruppe (1) nach einem der Ansprüche 1 bis 3, **dadurch gekennzeichnet, dass** die magnetische Komponente (4) die Form eines Hohlzylinders aufweist, der sich entlang der Baugruppenachse (6) erstreckt, wobei insbesondere die Enden des ersten Leiterabschnitts (2a) und des zweiten Leiterabschnitts (2c), die mit den Enden des verbindenden Leiterabschnitts (2b) verbunden sind, an derselben axialen Position entlang der Baugruppenachse (6) angeordnet sind.

5. Hochleistungselektronikbaugruppe (1) nach Anspruch 4, **dadurch gekennzeichnet, dass** der Umriss des Hohlzylinders ein Zylinder ist, welcher eines von
• einer kreisförmigen Zylindergrundfläche,
• einer elliptischen Zylindergrundfläche und
• einer polygonalen Zylindergrundfläche mit scharfen oder abgerundeten Ecken aufweist, wobei insbesondere der Grundfläche ein regelmäßiges Vieleck ist, speziell ein Rechteck.

6. Hochleistungselektronikbaugruppe (1) nach Anspruch 4 oder 5,
**dadurch gekennzeichnet, dass**
die magnetische Komponente (4) eine dreidimensionale konkave oder topfähnliche Form aufweist, wobei der Magnetfeldsensor (3), der erste Leiterabschnitt (2a), der verbindende Leiterabschnitt (2b) und der zweite Leiterabschnitt (2c) von dem dreidimensionalen Umriss der magnetischen Komponente (4) umschlossen sind.

7. Hochleistungselektronikbaugruppe (1) nach einem der Ansprüche 1 bis 6,
**dadurch gekennzeichnet, dass**
der Magnetfeldsensor (3) ein Hall-Sensor ist.

8. Hochleistungselektronikbaugruppe (1) nach einem der Ansprüche 1 bis 7,
**dadurch gekennzeichnet, dass**
der Magnetfeldsensor (3) eine integrierte Schaltung ist, die ein Sensorelement umfasst.

9. Hochleistungselektronikbaugruppe (1) nach einem der Ansprüche 1 bis 8,
**dadurch gekennzeichnet, dass**
mindestens zwei Leiter (2), die jeweils einen ersten Leiterabschnitt (2a), einen verbindenden Leiterabschnitt (2b) und einen zweiten Leiterabschnitt (2c), die in Reihe geschaltet sind, aufweisen, sowie entsprechende Magnetfeldsensoren (3) entlang einer Multisensorachse angeordnet sind, wobei die Magnetfeldsensoren (3) auf einer gemeinsamen Leiterplatte angeordnet sind und magnetische Komponenten (4) jeden Magnetfeldsensor (3) und den entsprechenden ersten und zweiten Leiterabschnitt (2a, 2c) umgeben.

10. Hochleistungselektronikbaugruppe (1) nach Anspruch 9,
**dadurch gekennzeichnet, dass**
mindestens zwei Anordnungen von Leitern (2) und Magnetfeldsensoren (3) entlang von mindestens zwei parallelen Multisensorachsen angeordnet sind, wobei Magnetfeldsensoren (3) von benachbarten Multisensorachsen nebeneinander angeordnet sind.

## Revendications

1. Ensemble électronique de haute puissance (1) pour la mesure de courant électrique de haute puissance, comprenant
• un conducteur (2),
• un composant magnétique (4) pour réunir les lignes de champ magnétique générées par le courant électrique s'écoulant dans le conducteur (2), et
• un capteur de champ magnétique (3) pour déterminer le courant électrique s'écoulant dans le conducteur (2) en se basant sur un champ magnétique mesuré,
• le conducteur (2) incluant en série une première section conductrice (2a), une section conductrice de connexion (2b) et une seconde section conductrice (2c), la première section conductrice (2a) et la seconde section conductrice (2c) s'étendant le long d'un axe d'ensemble (6) depuis une première extrémité axiale (7) jusqu'à une seconde extrémité axiale (8) d'une zone de détection centrale (9) et la section conductrice de connexion (2b) connectant la première section conductrice (2a) à la seconde section conductrice (2c),
• le capteur de champ magnétique (3) étant disposé entre la première section conductrice (2a) et la seconde section conductrice (2c), et
• le composant magnétique (4) étant disposé en une forme annulaire, en particulier une forme annulaire fermée, autour de l'axe d'ensemble (6) et entourant le capteur de champ magnétique (3), la première section conductrice (2a) et la seconde section conductrice (2c),
**caractérisé en ce que**
la première section conductrice (2a), la section conductrice de connexion (2b) et la section conductrice de connexion (2c) sont conformées sous forme de sections d'un rail conducteur en forme de ruban, la largeur du rail conducteur en forme de ruban s'étendant parallèlement aux lignes de champ magnétique (5) au niveau de l'axe d'ensemble (6).

2. Ensemble électronique de haute puissance (1) selon la revendication 1,
**caractérisé en ce que**
la première section conductrice (2a), la section conductrice de connexion (2b) et la seconde section conductrice (2c) forment une boucle conductrice en forme de U.

3. Ensemble électronique de haute puissance (1) selon une des revendications 1 à 2,
**caractérisé en ce que**
le capteur de champ magnétique (3), la première section conductrice (2a), la seconde section conductrice (2c) et le composant magnétique (4) font partie d'une unité compacte de l'ensemble électronique de haute puissance (1).

4. Ensemble électronique de haute puissance (1) selon une des revendications 1 à 3,
**caractérisé en ce que**
le composant magnétique (4) a la forme d'un cylindre creux s'étendant le long de l'axe d'ensemble (6), les extrémités de la première section conductrice (2a) et de la seconde section conductrice (2c) connectant les extrémités de la section de connexion (2b) étant disposées à la même position axiale le long de l'axe d'ensemble (6).

5. Ensemble électronique de haute puissance (1) selon la revendication 4,
**caractérisé en ce que** le contour du cylindre creux est un cylindre ayant une base parmi :
• une base de cylindre circulaire,
• une base de cylindre elliptique, et
• une base de silanes polygonale avec des coins aigus ou arrondis, la base étant en particulier un polygone régulier, plus particulièrement un rectangle.

6. Ensemble électronique de haute puissance (1) selon une des revendications 4 ou 5,
**caractérisé en ce que**
le composant magnétique (4) a une forme concave ou de type pot tridimensionnelle, le capteur de champ magnétique (3), la première section conductrice (2a), la section conductrice de connexion (2b) et la seconde section conductrice (2c) étant renfermées dans le contour tridimensionnel du composant magnétique (4).

7. Ensemble électronique de haute puissance (1) selon une des revendications 1 à 6,
**caractérisé en ce que**
le capteur de champ magnétique (3) est un capteur Hall.

8. Ensemble électronique de haute puissance (1) selon une des revendications 1 à 7,
**caractérisé en ce que**
le capteur de champ magnétique (3) est un circuit intégré comprenant un élément de détection.

9. Ensemble électronique de haute puissance (1) selon une des revendications 1 à 8,
**caractérisé en ce**
**qu'**au moins deux conducteurs (2) incluant chacun en série une première section conductrice (2a), une section conductrice de connexion (2b) et une seconde section conductrice de connexion (2c), de même que des capteurs de champ magnétique correspondants (3), sont disposés le long d'un axe à capteurs multiples, des capteurs de champ magnétique (3) étant disposés sur un circuit imprimé commun et des composants magnétiques (4) entourant chaque capteur de champ magnétique (3) et les première et seconde sections conductrices correspondantes (2a, 2c).

10. Ensemble électronique de haute puissance (1) selon la revendication 9,
**caractérisé en ce**
**qu'**au moins deux agencements de conducteurs (2) et capteurs de champ magnétique (3) sont disposés le long d'au moins deux axes à capteurs multiples parallèles, les capteurs de champ magnétique (3) d'axes à capteurs multiples adjacents étant disposés de manière à être adjacents les uns aux autres.
